# FASCICULE DE BREVET EUROPEEN

(11) **EP 1 344 249 B1**
(45) Date de publication et mention de la délivrance du brevet: **18.01.2017**
(21) Numéro de dépôt: 01993021.3
(22) Date de dépôt: 05.11.2001
(51) Int. Cl.: H01L 21/762

(54) **PROCÉDÉ DE FABRICATION D'UNE STRUCTURE EMPILÉE COMPRENANT UNE COUCHE MINCE ADHÉRANT À UN SUBSTRAT CIBLE**
HERSTELLUNGSVERFAHREN EINER STAPELSTRUKTUR MIT EINER AN EIN ZIELSUBSTRAT ANGEFÜGTEN DÜNNEN SCHICHT
METHOD FOR MAKING A STACKED STRUCTURE COMPRISING A THIN FILM ADHERING TO A TARGET SUBSTRATE

(30) Priorité: 06.11.2000 FR 0014170
(43) Date de publication de la demande: 17.09.2003
(73) Titulaire: Commissariat à l'Énergie Atomique et aux Énergies Alternatives, 75015 Paris (FR)
(72) Inventeur: MORICEAU, Hubert, F-38120 SAINT-EGREVE (FR); ASPAR, Bernard, F-38140 RIVES (FR); JALAGUIER, Eric, Le Penet, F-38410 SAINT-MARTIN-D'URIAGE (FR); LETERTRE, Fabrice, F-38000 GRENOBLE (FR)
(74) Mandataire: Ahner, Philippe
(86) Numéro de dépôt international: PCT/FR2001/003401
(87) Numéro de publication internationale: WO 2002/037556

(56) Documents cités:
- WO-A-00/19499
- FR-A- 2 781 082
- US-A- 5 391 257
- HAMAGUCHI T ET AL: "NOVEL LSI/SOI WAFER FABRICATION USING DEVICE LAYER TRANSFER TECHNIQUE" WASHINGTON, DEC. 1 - 4, 1985,WASHINGTON, IEEE,US, vol. -, 1 décembre 1985 (1985-12-01), pages 688-691, XP002037723
- ISHIKAWA Y ET AL: "EFFECTS OF ELECTRON TUNNELING INTO A SINGLE-CRYSTALLINE SI LAYER THROUGH AN ULTRATHIN BURIED OXIDE" EXTENDED ABSTRACTS OF THE INTERNATIONAL CONFERENCE ON SOLID STATE DEVICES AND MATERIALS,JAPAN SOCIETY OF APPLIED PHYSICS. TOKYO,JA, septembre 1998 (1998-09), pages 182-183, XP000823131

## Description

### DOMAINE TECHNIQUE

La présente invention concerne un procédé de fabrication d'une structure empilée comprenant une couche mince adhérant à un substrat cible. L'invention s'applique notamment dans le domaine des semi-conducteurs.

### ETAT DE LA TECHNIQUE ANTERIEURE

Le document FR-A-2 681 472 (correspondant au brevet américain 5 374 564) décrit un procédé de fabrication de films minces de matériau semi-conducteur. Ce document divulgue que l'implantation d'un gaz rare et/ou d'hydrogène dans un substrat en matériau semi-conducteur est susceptible de créer une couche fragilisée pouvant comporter des microcavités ou de microbulles (encore désignées par le terme "platelets" dans la terminologie anglo-saxonne) à une profondeur voisine de la profondeur moyenne de pénétration des ions implantés. Ce substrat est mis en contact intime, par sa face implantée avec un support servant de raidisseur. En outre, un traitement thermique peut être appliqué à une température suffisante pour induire une interaction (ou coalescence) entre les microcavités ou les microbulles conduisant à une séparation ou fracture du substrat semi-conducteur en deux parties : un film mince semi-conducteur adhérant au raidisseur d'une part, le reste du substrat semi-conducteur d'autre part qui peut être à son tour recyclé comme substrat donneur ou comme support. La séparation a lieu à l'endroit où les microcavités ou microbulles sont présentes, c'est-à-dire le long de la couche de microcavités. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Par implantation ionique on entend tout type d'introduction des espèces définies précédemment seules ou en combinaison. On peut citer le bombardement ionique, la diffusion, etc.

Ce procédé peut également s'appliquer à la fabrication d'un film mince de matériau solide autre qu'un matériau semi-conducteur (un matériau conducteur ou diélectrique), cristallin ou non. Ce film peut être monocouche ou multicouche (voir par exemple le document FR-A-2 748 850).

Ce procédé permet de réaliser à un coût avantageux des plaquettes, par exemple des plaquettes SOI, de qualité électronique par transfert d'un film de silicium sur un substrat de silicium recouvert d'une couche d'oxyde.

L'article « A new characterization process used to qualify SOI films » de H. MORICEAU et al. paru dans E.C.S. Proc. Vol. 99-3, p. 173, divulgue qu'il est possible de coller une plaquette SOI réalisée par un tel procédé sur un substrat de silicium oxydé. Après retrait du substrat de silicium de la plaquette SOI et de sa couche d'oxyde au moyen d'une attaque chimique sélective (par exemple à base de HF), on obtient une autre plaquette SOI à film de silicium inversé puisque la face libre de ce film est celle qui adhérait à la couche d'oxyde enterrée de la plaquette SOI initiale. La raison de cette démarche était de pouvoir faire un examen des défauts du film de silicium. En effet, l'objectif de cette étude était de localiser les défauts dans l'épaisseur du film et non pas de réaliser une nouvelle structure.

Les articles « Evaluation of defects in surface Si near Si/BOX interface in SIMOX wafers » de M. SUDOU et al. paru dans E.C.S. Proc. Vol. 97-23, p. 119 et « SIMOX technology and applications to wafer bonding » de A.J. AUBERTON-HERVE et al. paru dans E.C.S. Proc. Vol. 95-7, p. 12 divulguent des expériences de collage d'une plaquette SOI obtenue par le procédé SIMOX directement sur un substrat en silicium ou en silice pure. Ce procédé comporte une seule étape de collage et est suivi du retrait du substrat de la plaquette SOI. Le but de ces expériences était également l'examen des défauts du film de silicium. Une approche analogue a été utilisée dans l'article "Ultra thin silicon films directly bonded onto silicon wafers" de F. FOURNEL et al., paru dans Materials Science and Engineering, B 73 (2000), pages 42 à 46, pour réaliser un réseau de dislocations dans un plan d'interface, défini lors de la mise en contact d'un film mince et d'un substrat monocristallin de silicium. L'article ne renseigne pas sur le moyen d'obtenir la couche mince de la structure empilée tel que décrit par l'invention.

Le document FR-A-2 725 074 (correspondant au brevet américain 5 863 830) divulgue un procédé de fabrication d'une structure comportant un film mince semi-conducteur adhérant à un substrat cible. A l'origine, le film mince est lié à un substrat initial par une première énergie de liaison. Le film mince est ensuite transféré du substrat initial vers le substrat cible en mettant en oeuvre des forces d'arrachement, permettant de vaincre la première énergie de liaison, et une adhésion du film mince sur le substrat cible. Ce transfert du film mince peut se faire au moyen d'un substrat intermédiaire ou manipulateur qui est à son tour séparé du film mince par arrachement. Ce procédé nécessite de contrôler les énergies de liaison entre les différentes interfaces de scellement associées au film mince pour permettre les arrachements successifs.

La technique connue sous le sigle BESOI n'utilise pas la séparation d'un film mince par implantation d'espèces gazeuses. Une de ses principales caractéristiques est l'utilisation d'une couche d'arrêt cristalline permettant une attaque chimique dite sélective tout en supportant une couche monocristalline, typiquement du silicium. Cette couche d'arrêt est une couche monocristalline ou une couche épitaxiée. Il peut s'agir d'une couche de silicium dopé, une couche obtenue par épitaxie de matériau cristallin de nature différente de celle du film mince (SiₓGe₁₋ₓ par exemple), une couche monocristalline de silicium rendue poreuse, réalisée dans la partie massive du substrat de silicium. Cette technique ne permet pas d'utiliser une couche d'arrêt amorphe si on désire déposer un film monocristallin sur cette couche d'arrêt. Elle ne renseigne pas sur l'utilisation d'un substrat intermédiaire.

Le procédé connu de réalisation de structures en couches minces, dit procédé direct et décrit dans FR-A-2 681 472, basé sur l'implantation d'hydrogène, l'adhésion moléculaire avec un support final et la séparation dans et/ou au voisinage de la zone implantée, ne permet pas d'obtenir facilement et/ou avec une qualité suffisante certaines structures ayant des propriétés spécifiques. Dans les cas suivants, le procédé direct n'est pas applicable simplement et la solution technique à apporter, objet de cette invention, ne découle pas d'une simple adaptation du procédé.

Un premier cas concerne la réalisation de structures de films empilés minces et/ou très minces possédant une couche cristalline présente à la surface d'une couche amorphe. Un premier exemple est la réalisation de films devant avoir des épaisseurs inférieures à quelques dizaines de nanomètres, par exemple des films de silicium de 20 nm d'épaisseur sur des films de SiO₂ de 20 nm d'épaisseur et adhérant à un support en silicium massif. Des défauts de collage sont alors souvent révélés lors de l'étape de séparation du procédé direct, ce qui peut être mis en évidence lorsque le procédé met en oeuvre une étape de séparation comportant un traitement thermique à basse température (par exemple inférieure à 500°C) assisté ou non mécaniquement. Un deuxième exemple est celui où la structure en films minces ayant des propriétés spécifiques est soumise à des traitements thermiques à des températures supérieures à celles de traitements thermiques subis avant, pendant ou après l'amincissement de l'un des substrats utilisés (par exemple en utilisant l'amincissement par le procédé direct). Des défauts de collage, par exemple des bulles gonflées de gaz, peuvent alors apparaître au détriment de la qualité de la structure.

Un deuxième cas concerne la réalisation de structures où les forces de collage sont très faibles avant l'étape de séparation par le procédé direct. Par exemple, pour certaines conditions de préparation des surfaces avant la mise en contact (nettoyage, niveau de procédé d'élaboration de composant d'où il résulte une certaine rugosité de surface, etc.), le collage entre le support final et la plaque génératrice du film à transférer présente une énergie très faible. L'étape de séparation du procédé direct ne peut pas alors s'effectuer.

Un troisième cas concerne la réalisation de structures empilées de matériaux dont les coefficients de dilatation thermique sont trop différents. Si le matériau du film à transférer et le matériau du support final ont des coefficients de dilatation thermique trop différents, le collage va céder avant la séparation par le procédé direct si un traitement thermique est appliqué au collage. C'est par exemple le cas du silicium et du saphir dont les coefficients de dilatation thermique sont dans un rapport de l'ordre de 2.

Un quatrième cas concerne la réalisation de structures où les forces de collage doivent être faibles ou très faibles après l'étape de séparation par le procédé direct. Il peut être souhaité que l'énergie de scellement de la structure empilée reste faible après l'étape de séparation par le procédé direct, voire inférieure à celle nécessaire à la séparation, pour procurer ultérieurement un décollement au niveau de l'interface de collage. Ceci s'applique en particulier lorsque divers traitements peuvent renforcer l'interface de scellement. Dans un premier exemple qui correspond par exemple à une application de substrat cible démontable pour être récupéré, l'amincissement, par oxydation sacrificielle à 950°C d'un film superficiel en silicium d'une structure SOI, provoque une augmentation de l'énergie de scellement supérieure à 1 J/m², ce qui est défavorable à la séparation ultérieure de la structure empilée du substrat cible. Dans un deuxième exemple, il peut être nécessaire de traiter (par diffusion thermique d'espèces, oxydation localisée, etc.) tout ou partie d'une des couches, ce qui est défavorable au décollement de la structure empilée puisque ces opérations participent au renforcement de l'énergie de scellement. Il peut être également souhaité d'avoir une énergie de scellement très faible dans la structure finale par exemple dans le cas où l'on veut réaliser un dépôt sur cette structure, ce dépôt présentant une forte contrainte par rapport à tout ou partie de la structure empilée et du substrat cible. Cette interface faible joue alors le rôle de zone d'accommodation des contraintes. Cette application est du domaine de la compliance du support.

Un cinquième cas concerne la réalisation de structures empilées de matériaux hétérogènes. L'utilisation de matériaux de natures différentes par exemple du silicium ou de l'oxyde thermique (diélectriques divers, matériaux métalliques, semi-conducteurs, supra-conducteurs, etc.) peut être à l'origine de défauts de collage mis en évidence au cours du procédé direct. Par exemple, le scellement d'une lame de silicium recouverte d'un film de nitrure de silicium avec un film de nitrure de silicium recouvrant lui-même une lame de silicium entraîne souvent des défauts de collage facilement mis en évidence lors de l'étape de séparation par le procédé direct. On entend ici par lame un substrat ou un film ou une structure empilée recouvert en surface par le film cité.

Un sixième cas concerne la réalisation de structures empilées dans lesquelles un changement de phase ou de nature d'un matériau peut intervenir. Par exemple, l'utilisation de certains matériaux n'est pas compatible avec les budgets thermiques éventuellement employés dans le procédé direct. Ainsi, une structure empilée constituée d'un film de silicium, d'un film de palladium et d'une plaque de silicium produit, au-dessus de 200°C, un siliciure apte à donner un bon collage. A plus haute température, le scellement se dégrade, par exemple au-dessus de 900°C, température typiquement utilisée pour faire l'oxydation d'un film de silicium en vue de réduire son épaisseur. Un autre exemple concerne les applications en optique où un miroir métallique peut être rapporté par adhésion moléculaire sur une lame de silicium. Ce miroir métallique ne supportant pas de traitement thermique au-delà de quelques dizaines de °C, il n'est pas envisageable d'appliquer les budgets thermiques qui peuvent être éventuellement utilisés dans le procédé de séparation.

Le procédé direct ne permet pas, dans certains cas, de réaliser des structures de films empilés avec conservation d'une surface spécifique, dite face avant.

A ce propos, on peut citer en premier exemple la réalisation de structures empilées dans lesquelles le film superficiel obtenu est difficile à polir. Par exemple, la structure amincie par le procédé direct présente après l'étape de séparation une rugosité de surface à diminuer en fonction de l'application prévue. Cette diminution de la rugosité peut être classiquement obtenue par exemple par polissage mécano-chimique (CMP) dans le cas du silicium. Pour beaucoup de matériaux, par exemple pour les matériaux "durs", ce polissage est soit inadapté (manque d'efficacité), soit trop long (coût industriel important). C'est le cas d'une structure amincie par le procédé direct terminé en surface par exemple par un film de saphir, de SiC ou de diamant. Le film "dur" présente une micro-rugosité de surface à diminuer pour l'application voulue. Pour ce type de matériau, le polissage par CMP est très long à mettre en oeuvre et l'homogénéité de polissage sur la structure est très difficile à maîtriser. Le surcoût impliqué est alors important si on veut atteindre une qualité de type épitaxiale ("epi-ready" en anglais).

On peut citer également la réalisation de structures empilées dans lesquelles l'un des films possède au moins une caractéristique différente sur ses deux faces. C'est le cas si la structure obtenue par le procédé direct présente, après l'étape de séparation, une surface incompatible avec l'utilisation prévue. Par exemple, un film de SiC monocristallin par son caractère polaire présente la caractéristique d'avoir, sur une face, une surface constituée majoritairement d'atomes de silicium (surface dite de type Si) et, sur l'autre face, une surface constituée majoritairement d'atomes de carbone (surface dite de type C). La reprise de croissance par épitaxie sur SiC suppose de disposer d'une surface libre de type Si. Or, le transfert d'un film de SiC, par exemple par le procédé direct, s'accompagne d'un changement, par retournement, de la nature de la surface. La surface libre initiale est de type Si car c'est la face facile à polir avec SiC et la face facile à sceller par adhésion moléculaire. La face libre est donc de type C après transfert par le procédé direct. Il en va de même pour une couche en GaN.

Le document US-A-5 391 257 divulgue un procédé de transfert d'un film mince depuis un substrat initial vers un substrat cible. Le procédé comprend la formation d'une couche mince à partir d'un substrat initial, la couche mince présentant une face libre, la mise en contact adhérent de ladite face libre avec un support intermédiaire, l'amincissement du substrat initial pour exposer une face libre de la couche mince opposée à la première face libre, la mise en contact adhérent d'une face du substrat cible avec au moins une partie de la face libre de la couche mince, le retrait d'au moins une partie du support intermédiaire.

Le document « Novel LSI/SOI Wafer Fabrication using Device Layer Transfer Technique » de T. Hamaguchi et al., Washington, 1-4 décembre 1985, Washington, IEEE, US, vol. 1, 1er décembre 1985, pages 688-691, divulgue un procédé de fabrication d'un dispositif comprenant un niveau LSI. Une couche épitaxiale est formée sur un substrat initial. Le niveau LSI est formé dans cette couche mince. La face libre de la couche mince est traitée et mise en contact adhérent avec un support intermédiaire. Le substrat initial est aminci pour exposer une face libre de la couche mince. Cette face libre est mise en contact adhérent avec une face d'un substrat cible. Le support intermédiaire est ensuite retiré.

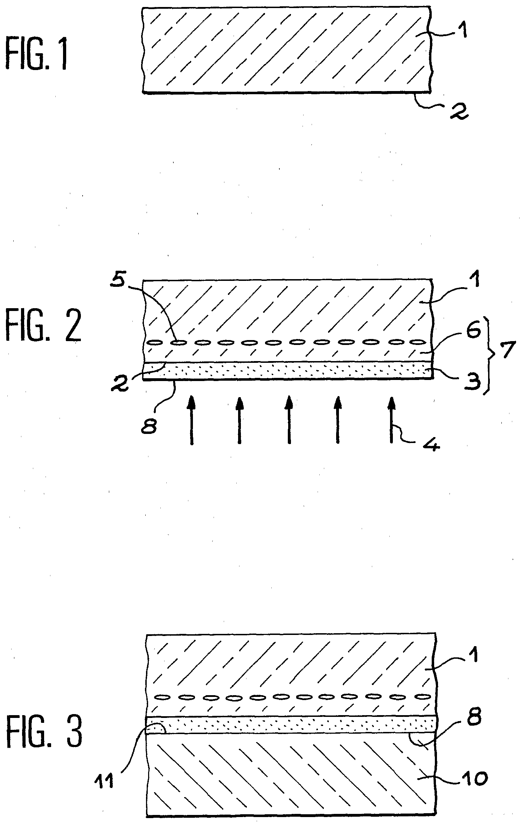

Le document « Effects of electron tunneling into a single-crystalline Si layer through an ultrathin buried oxide » de Y. Ishikawa et al., Extended Abstracts of the International Conference on Solid State Devices and Materials, Japan Society of Applied Physics, Tokyo, Japon, septembre 1998, pages 182-183, divulgue un procédé de fabrication d'une structure SOI. La figure 1 montre un substrat BESOI dont la couche de silicium superficielle est recouverte d'une couche de SiO₂, et un substrat de silicium dopé n⁺. Les deux substrats sont fixés l'un à l'autre par l'intermédiaire de la couche de SiO₂. Ensuite, le substrat BESOI est traité par gravure pour ne garder que la couche mince de silicium superficiel. On obtient une structure SOI constituée du substrat de silicium dopé n⁺, de la couche de SiO₂ et de la couche mince de silicium. Par oxydation, on obtient une couche mince de silicium d'épaisseur réduite (entre 10 et 50 nm) recouverte d'une couche de SiO₂ de 70 nm d'épaisseur.

Le document FR-A-2 781 082 divulgue une structure semiconductrice en couche mince comportant une couche de répartition de chaleur. Le procédé de fabrication comprend le dépôt de couches sur un premier substrat, le collage du premier substrat, côté couches déposées, sur un second substrat et la réduction d'épaisseur du premier substrat.

### Exposé de l'invention

La présente invention permet de remédier aux inconvénients de l'art antérieur et de fournir une structure empilée comprenant soit un film présentant certaines propriétés spécifiques, soit un film présentant au moins une surface à propriété(s) spécifique(s).

L'invention résulte du fait surprenant constaté par les inventeurs que, contrairement au procédé direct pour lequel il y a scellement sur le substrat cible puis amincissement, lorsque l'amincissement du substrat initial a lieu avant le scellement de la couche mince sur le substrat cible, tous les défauts répertoriés ci-dessus peuvent être évités. Pour inverser ces étapes de scellement et d'amincissement, il faut passer par l'utilisation d'un ou de plusieurs supports intermédiaires.

L'invention a donc pour objet un procédé de fabrication d'une structure empilée tel que décrit dans la revendication 1.

On entend par retrait à l'étape e) toute technique permettant d'éliminer le substrat initial ou le support intermédiaire. On peut citer en particulier le décollement, la fracture (liée à la création d'une zone fragilisée par introduction d'espèces gazeuses), la gravure mécanique et/ou chimique. Suivant le type d'amincissement et de retrait, le substrat et le support peuvent être réutilisés.

Selon un mode de réalisation particulier, le substrat cible n'est qu'un support provisoire pour la couche mince, lesdites étapes du procédé étant en totalité ou en partie répétées, le substrat cible étant assimilé au substrat initial ou au support intermédiaire.

Ainsi, le procédé selon l'invention permet le transfert de la couche mince d'un support vers un autre support autant de fois que nécessaire pour obtenir une structure empilée présentant les caractéristiques souhaitées et en particulier un empilement avec des niveaux technologiques de composant.

A l'étape b) et/ou à l'étape d), la compatibilité de ladite structure peut être obtenue par la formation, à l'étape a), d'une couche mince permettant d'éviter des défauts d'adhérence respectivement lors de l'amincissement de l'étape c) et lors du retrait de l'étape e). Cette compatibilité peut résulter de l'épaisseur donnée à la couche mince et/ou du matériau ou des matériaux constituant ladite couche mince. La nature du support intermédiaire et/ou du substrat cible, en contact avec la couche mince, peut être choisie de manière à éviter une incompatibilité liée à un changement de phase de matériaux de la structure obtenue. La nature du support intermédiaire et/ou du substrat cible, en contact avec la couche mince, peut être choisie de manière à éviter une incompatibilité liée à une hétérogénéité de matériaux de la structure obtenue. La nature du support intermédiaire et/ou du substrat cible, en contact avec la couche mince, peut être choisie de manière à éviter une incompatibilité liée à une différence de coefficient de dilatation thermique avec la couche mince. Pour permettre cette compatibilité, la couche mince et/ou le support intermédiaire et/ou le substrat cible peut (peuvent) comprendre au moins une couche additionnelle présentant une (des) face(s) de contact. Dans ce cas, avant l'étape d), la couche additionnelle peut être pourvue de tout ou partie d'au moins un composant. La couche additionnelle peut être constituée par un oxyde ou du silicium polycristallin ou du silicium amorphe.

Les étapes a) et c) peuvent être telles que la première face de contact de la couche mince et/ou du support intermédiaire présente une rugosité inférieure respectivement à celle de sa deuxième face de contact et/ou du substrat cible, la compatibilité de structure de l'étape d) étant obtenue grâce à la mise en contact adhérent de la deuxième face de contact de la couche mince et au retrait du support intermédiaire.

Le contact adhérent de la première face de contact et/ou de la deuxième face de contact de la couche mince permettant ladite compatibilité à l'étape b) et/ou à l'étape d) peut résulter de l'utilisation d'un traitement permettant le contact adhérent. Le traitement permettant le contact adhérent peut être choisi, seul ou en combinaison, parmi les traitements suivants : polissage mécano-chimique et/ou ionique, interposition d'une couche intermédiaire entre une face de contact correspondante de la couche mince et le support intermédiaire ou le substrat cible, traitement thermique et traitement chimique. Le traitement peut être réalisé à haute température grâce à la compatibilité de la structure.

Avantageusement, la mise en contact adhérent de l'étape b) et/ou de l'étape d) est réalisée par adhésion moléculaire.

La première face de contact de la couche mince peut présenter une polarité en surface (polarité liée à la nature des atomes de cette surface) différente de celle de sa deuxième face de contact, la compatibilité de structure de l'étape d) étant obtenue grâce à la mise en contact adhérent de la deuxième face de contact de la couche mince et du substrat cible, et grâce au retrait du support intermédiaire de la première face de contact de la couche mince qui devient ainsi une face libre. La compatibilité de structure réalisée à l'étape d) peut être obtenue grâce à la mise en contact adhérent de la deuxième face de contact de la couche mince avec le substrat cible avec une énergie de liaison apte à un éventuel retrait du substrat cible après l'étape e). Avantageusement, cette énergie de liaison est faible. Entre l'étape c) et l'étape d), il peut être prévu une étape intermédiaire consistant à réaliser des éléments dans la deuxième face de contact de la couche mince et/ou dans le substrat cible, la structure obtenue après l'étape d) étant compatible avec la présence desdits éléments. Ces éléments peuvent être des cavités ou tout ou partie de composants (microélectroniques, optroniques.) et peuvent réaliser une certaine topologie de surface. Avant l'étape d), il peut être prévu une étape intermédiaire consistant en une opération de détourage permettant d'isoler au moins une zone de la deuxième face de contact, l'étape d) mettant en contact adhérent au moins une de ces zones avec le substrat cible. L'opération de détourage peut éventuellement avoir lieu même avant l'étape a). Après l'étape e) de retrait, la ou les zones de la couche qui ne sont pas en contact adhérent avec le substrat cible subsistent sur le support intermédiaire et peuvent faire l'objet de transfert ultérieur.

L'étape a) peut être réalisée à partir d'un substrat recouvert d'au moins une couche de matériau. Dans ce cas, après l'étape e), le procédé peut comporter une étape consistant à éliminer la couche de matériau recouvrant le substrat de l'étape a).

Le substrat initial peut être monocouche ou multicouche. Il peut en particulier comporter une couche épitaxiée. Il en va de même pour le substrat cible et pour le support intermédiaire.

Selon un mode préféré, le retrait d'au moins une partie du support intermédiaire peut être effectué par une introduction d'espèces gazeuses effectuée soit au travers de la couche mince après mise en contact, soit au travers de la face de contact du support intermédiaire avant ou après sa mise en contact adhérent avec la première face de contact de la couche mince, cette introduction d'espèces gazeuses formant une couche fragilisée permettant le retrait par fracture d'une partie du support intermédiaire éventuellement recouvert d'un film de la couche mince. Dans ce cas, le support intermédiaire peut être réutilisé par exemple comme un nouveau support.

Eventuellement, la structure empilée obtenue à l'issue de l'étape e) est amincie du côté de la première face de contact.

Le procédé peut mettre en oeuvre un substrat initial de très bonne qualité et donc d'un coût élevé comme par exemple du silicium monocristallin de 300 mm de diamètre, un support intermédiaire compatible avec le substrat initial au sens de l'étape b), par exemple un substrat de silicium monocristallin recouvert d'un film d'oxyde SiO₂, un substrat cible en silicium polycristallin ou monocristallin de moindre qualité que le silicium du substrat initial, la couche mince comportant par exemple de l'oxyde de silicium sur du silicium monocristallin provenant du substrat initial. De la même façon, le substrat cible pourra être autre que du silicium. A la fin du procédé, le film obtenu sur le substrat cible est alors de très bonne qualité. En outre, le substrat initial peut être réalisé et, suivant sa qualité ou son coût, le support intermédiaire sera réutilisable ou sacrifiable. Il peut aussi mettre en oeuvre un substrat initial en SiC ou en GaAs, un support intermédiaire en SiC ou en GaAs, un substrat cible en SiC ou en GaAs de moindre qualité que le matériau du substrat initial, la couche mince comportant du SiC ou du GaAs provenant du substrat initial.

La couche mince peut être une couche de matériau choisi parmi Si, GaN, SiC, LiNbO₃, Ge, GaAs, InP, le saphir et les semi-conducteurs.

La présente invention procure, entre autres, les avantages suivants :
- On peut transférer un film monocristallin de bonne qualité cristalline alors que la couche d'arrêt pour l'amincissement du support intermédiaire est une couche amorphe.
- On peut utiliser un support intermédiaire recyclable, par exemple en maîtrisant son énergie de scellement, si le substrat intermédiaire (qualité, nature.) est d'un coût important. Ainsi un support intermédiaire de SiC polycristallin peut être utilisé pour le transfert d'un film monocristallin de SiC de fort coût et/ou de grande qualité. A titre d'exemple, la maîtrise de l'énergie de scellement peut être assurée par le contrôle de la rugosité d'une couche additionnelle de SiO₂ déposée sur la couche mince ou sur le support intermédiaire. En variante de la maîtrise de l'énergie de scellement du support intermédiaire, il est possible aussi d'utiliser un film consommable (par exemple un oxyde) à la surface de ce support intermédiaire pour permettre de le recycler (technique du "lift-off").
- On peut choisir aisément l'épaisseur de l'oxyde enterré final ou de la couche intermédiaire (diélectrique, métallique.).
- Le principe de l'invention peut être appliqué à des couches en d'autres matériaux monocristallins ou non que le silicium pour (au moins) un des films de la structure empilée. En particulier, on peut appliquer le procédé à un film de saphir, de SiC, de GaN, de LiNbO₃, de Ge, de GaAs, de InP sur n'importe quel support.
- Ce même principe peut être appliqué à d'autres types de substrat cible que le silicium, par exemple le quartz ou n'importe quel substrat, avantageusement un substrat bas coût (verre, plastique, céramique.).
- Ce procédé peut être appliqué à tout type de film semi-conducteur, par exemple aux semi-conducteurs III-V, II-VI et IV ou à un film de diamant, de nitrure ou à tout type de film, par exemple des oxydes tels que Al₂O₃, ZrO₂, SrTiO₃, LaAlO₃, MgO, YBaₓCu_{y}O_{z}, SiOₓN_{y}, RuO₂ ou à d'autres matériaux, en particulier piézoélectriques, supraconducteurs, isolants, métalliques, pyroélectriques, monocristallins ou non.
- On peut appliquer ce procédé à des matériaux ayant des surfaces à caractères polaires.
- On peut appliquer ce procédé de façon répétitive à des matériaux pour obtenir par exemple des structures multicouches complexes.
- Le principe de fabrication uniquement d'un film monocristallin par exemple de silicium sur un support final peut être avantageusement utilisé dans une application où le support final est une structure d'au moins une couche processée ou non. Ce film monocristallin de silicium transféré devient alors lui-même l'objet d'étapes technologiques en vue de l'élaboration d'un composant. Ce principe, s'il est réitéré, permet un empilement 3D de niveaux technologiques de composants.
- Le procédé selon l'invention permet de pallier au cours d'une même mise en oeuvre à plusieurs types d'incompatibilités. Pour cela, il peut requérir l'utilisation successive d'un ou de plusieurs supports intermédiaires.
- Les substrats initiaux, substrats cibles et supports intermédiaires peuvent être des structures empilées.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente, en coupe transversale, un substrat appelé substrat initial auquel s'applique la présente invention,
- la figure 2 représente, en coupe transversale, le substrat initial recouvert d'une couche de matériau et subissant une étape d'implantation ionique lors de la mise en oeuvre du procédé selon l'invention,
- la figure 3 illustre l'étape de mise en contact adhérent du substrat initial, via la couche de matériau, avec un support intermédiaire selon la présente invention,
- la figure 4 illustre l'étape d'élimination d'au moins une partie du substrat initial selon la présente invention,
- la figure 5 illustre l'étape de mise en contact adhérent avec une face d'un substrat cible, via une éventuelle couche, selon la présente invention,
- la figure 6 représente la structure empilée obtenue par le procédé selon l'invention.

### Description détaillée de modes de réalisation de l'invention

Plusieurs exemples de mise en oeuvre de l'invention vont être décrits. Ces exemples étant des variations sur un procédé de mise en oeuvre de l'invention, on va d'abord décrire sommairement, selon un exemple, ce procédé grâce aux figures 1 à 6.

La figure 1 montre, en coupe transversale, une plaque 1 en silicium de 725 *µ*m d'épaisseur et de 200 mm de diamètre constituant le substrat initial. La face 2 du substrat initial 1 est oxydée sur une épaisseur de 400 nm par traitement thermique pour fournir une couche d'oxyde 3 (voir la figure 2). On pourrait aussi utiliser une multicouche sur le substrat 1.

On procède ensuite à une implantation ionique du substrat initial 1 par des espèces gazeuses 4 au travers de sa face 2, donc en traversant également la couche d'oxyde 3 comme le montre la figure 2. Les espèces gazeuses 4 sont par exemple des ions hydrogène implantés à une énergie de 75 keV et selon une dose d'environ 6.10¹⁶ atomes/cm². On induit ainsi une couche fragilisée 5 dans un plan parallèle à la face 2.

La partie du substrat 1 comprise entre la face 2 et la couche fragilisée 5 constitue un film 6. L'ensemble constitué par l'empilement du film 6 et de la couche d'oxyde 3 constitue une couche mince 7. La couche mince 7 présente une face libre 8 appelée première face de contact.

La première face de contact 8 est nettoyée pour la rendre apte à une adhésion moléculaire, par exemple par une préparation destinée à la rendre suffisamment hydrophile, et est mise en contact par adhésion moléculaire avec une face 11 d'une autre plaque de silicium 10 appelée support intermédiaire comme le montre la figure 3. Dans une variante d'application, une couche (adhésif, couche fusible.) apte à provoquer une adhésion avec le support intermédiaire peut être réalisée en vue de l'adhésion avec ledit support.

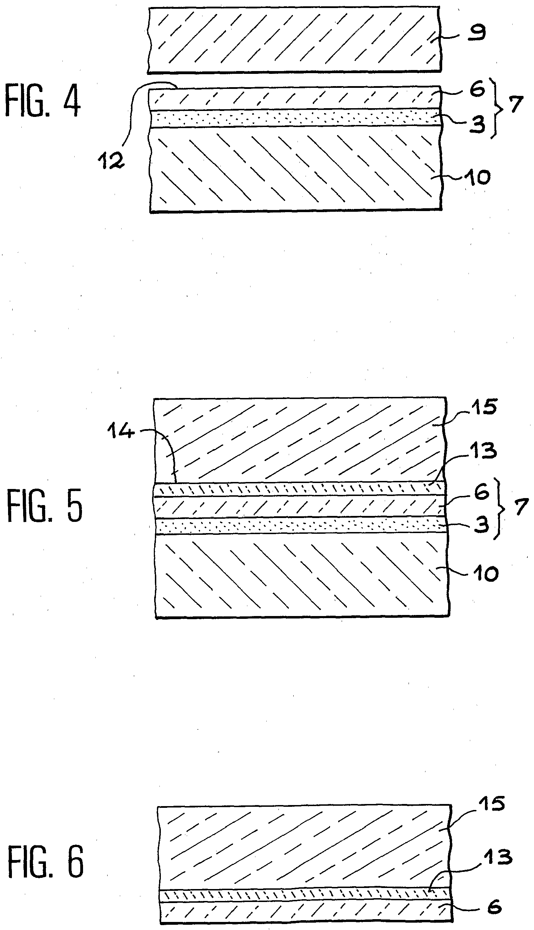

L'ensemble constitué par le substrat initial 1 et le support intermédiaire 10 est soumis à un traitement de séparation, un traitement thermique, afin de séparer par fracture le film 6 du reste 9 du substrat initial 1 (voir la figure 4). Le film 6 reste solidaire du support intermédiaire 10 et présente une face libre 12.

Avantageusement, le scellement de la couche mince 7 sur le support intermédiaire 10 est renforcé par un traitement thermique à haute température. Suivant la température, l'énergie d'adhésion moléculaire entre ces deux parties peut alors atteindre par exemple une valeur de l'ordre de 1,5 J/m².

La face libre 12 du film 6 est alors lissée grâce à un traitement de surface, par exemple grâce à un polissage mécano-chimique, un recuit par exemple sous atmosphère partielle ou totale d'hydrogène, ou un bombardement par des ions isolés ou en amas ou une attaque chimique permettant d'enlever tout ou partie du film 6, libérant ainsi une face de la couche 3 dans le cas où la couche 3 est assez sélective par rapport au substrat intermédiaire. Elle peut être couverte d'un film 13 qui peut être multicouche et dont la face libre constitue la deuxième face de contact 14 (voir la figure 5). Le film 13 peut être obtenu par dépôt, par traitement thermique, par traitement chimique, etc.

Après nettoyage de la deuxième face de contact 14, celle-ci est mise en contact adhérent avec un substrat cible 15. Le scellement peut être renforcé par un traitement thermique à haute température.

Le support intermédiaire 10 est ensuite retiré par exemple par meulage complété par attaque chimique. La couche d'oxyde 3 peut aussi être retirée pour obtenir la structure empilée représentée à la figure 6 et constituée du substrat cible 15, du film 13 et du film 6.

Selon une première variante de mise en oeuvre, le film 13 peut être une couche d'oxyde de 20 nm d'épaisseur réalisée thermiquement à la surface 12 du film 6. Le substrat cible 15 peut être en silicium et oxydé en surface (par exemple sur 20 nm) ou non. Dans ce cas, le scellement du film 13 sur le substrat cible 15 peut être renforcé par un traitement à 1100°C ou une adhésion de type moléculaire. Comme précédemment, un scellement par un matériau adhésif ou fusible ou autre peut aussi être utilisé. On obtient alors une structure empilée de qualité tout en évitant l'apparition de bulles à l'interface de scellement. Le support intermédiaire 10 est retiré par un meulage poursuivi par une attaque chimique dans une solution d'hydroxyde de tétraméthylammonium (TMAH) ou de potasse, la couche d'oxyde 3 servant alors de couche d'arrêt de gravure chimique du silicium. Cette couche d'oxyde 3 est éliminée au moyen d'une solution à base d'acide fluorhydrique. L'épaisseur finale du film 6 est adaptée par amincissement, par exemple au moyen d'une oxydation sacrificielle. Une épaisseur finale de 50 nm peut être obtenue avec une très bonne homogénéité.

Selon une deuxième variante de mise en oeuvre, la couche d'oxyde 3 formée sur le substrat initial 1 fait 400 nm d'épaisseur. L'implantation d'atomes d'hydrogène est effectuée sous les mêmes conditions que précédemment. Après la séparation du film de silicium 6 du reste 9 du substrat initial 1, le film 6 est aminci, par exemple par oxydation sacrificielle à 30 nm, et recouvert d'un oxyde 13 de 50 nm d'épaisseur. La deuxième face de contact 14 est scellée au substrat cible 15. Des traitements impliquant une haute température peuvent alors être effectués sans risque d'apparition de bulles à l'interface de collage.

Une troisième variante de mise en oeuvre permet de procurer une interface de scellement sur le substrat cible de faible énergie. Pour cela, la surface 12 du film 6, révélée par la séparation du film 6 du reste 9 du substrat initial (voir la figure 4), est lissée par exemple par un polissage mécano-chimique. On forme thermiquement un film d'oxyde 13 (voir la figure 5) de 1000 nm d'épaisseur. La surface libre du film 13 est alors rendue rugueuse avec une valeur moyenne RMS de 0,6 nm, par exemple par gravure au moyen d'une solution d'acide fluorhydrique à 10% pendant 12 minutes. Après nettoyage, la deuxième face de contact 14 est scellée au substrat cible 15. Ce substrat cible est un substrat de silicium, qui peut avoir été oxydé en surface, par exemple sur 1000 nm. Sa surface peut avoir été rendue rugueuse avec une valeur moyenne RMS de 0,6 nm par le même traitement chimique que celui mis en oeuvre pour le film 13. L'énergie de scellement est adaptable en fonction de la rugosité induite et d'un éventuel traitement thermique. A ce stade, il est possible d'avoir une énergie de scellement plus faible que celle nécessaire au bon déroulement du procédé direct, dite énergie de scellement seuil.

Le support intermédiaire 10 en silicium est ensuite retiré, par exemple par un meulage complété par une attaque chimique dans une solution de TMAH ou de potasse, la couche d'oxyde 3 servant de couche d'arrêt à la gravure. Cette couche d'oxyde 3 est éliminée par attaque au moyen d'une solution d'acide fluorhydrique et l'épaisseur finale du film 6 est adaptée par amincissement, par exemple par oxydation sacrificielle.

Cette variante de mise en oeuvre permet d'obtenir un film 6 d'épaisseur finale de 200 nm environ avec une très bonne homogénéité. L'énergie de scellement avec le substrat cible 15 est faible, ce qui permet de récupérer le film, ultérieurement au procédé, par décollement d'avec le substrat cible 15. De façon avantageuse, et avant de récupérer le film, on peut réaliser tout ou partie d'un composant, par exemple pour des applications de microélectronique, d'optoélectronique, photovoltaïques, de capteurs, etc. De façon avantageuse, suivant une autre application, on peut utiliser une telle structure empilée, comportant une énergie de scellement faible, pour y réaliser des dépôts ou reports de film. Une autre application de cette variante concerne les substrats à coût élevé.

Suivant une variante encore, on s'attachera à pouvoir réutiliser les substrats initiaux et intermédiaires. Suivant cette variante, la plaque initiale peut être en silicium monocristallin, de haute qualité et/ou de coût élevé, par exemple une plaque de 300 mm de diamètre. Le support cible peut être en silicium monocristallin, de moindre qualité, ou polycristallin, de faible coût. Les obstacles surmontés grâce à ce procédé seront, par exemple, des défauts d'adhérence ou l'apparition de bulles observables dans le procédé direct. Dans un premier exemple, lors de l'étape d), la face libre de la couche mince pourra être scellée directement sur le substrat cible, par exemple, dans le cas où l'application suppose un collage conducteur. Dans un deuxième exemple, lors de l'étape d), la face libre de la couche mince ou du substrat cible peut être recouverte d'un film d'oxyde, par exemple pour permettre l'adhésion sur le substrat cible de faible coût. Dans ce dernier exemple, l'oxyde permet un lissage de la surface à mettre en adhérence et le substrat cible sera du silicium polycristallin.

Dans cette variante de procédé, le substrat intermédiaire en silicium peut être de faible coût, par exemple polycristallin. Une couche additionnelle pour le lissage de surface, par exemple en SiO₂, sera avantageusement déposée sur le substrat intermédiaire.

Dans cette variante encore, le substrat intermédiaire peut être en silicium de haute qualité. Il est alors avantageux de le récupérer par exemple par une technique de lift-off ou par une implantation d'espèces gazeuses suivie d'une séparation ou par une technique prenant en compte, par exemple, une énergie d'adhésion assez faible après l'étape b) pour permettre une séparation, par exemple, par voie mécanique, pneumatique.

Dans tous les cas de cette variante, le substrat initial de haute qualité et/ou de coût élevé, par exemple en silicium de 300 mm de diamètre, sera récupéré avantageusement en utilisant, par exemple, lors de l'étape a) une implantation d'espèces gazeuses et lors de l'étape c) une séparation du reste du substrat initial.

Une quatrième variante de mise en oeuvre permet de procurer une interface de scellement sur le substrat cible de faible énergie afin de libérer le film et de récupérer le substrat cible. Cette variante de mise en oeuvre, qui a beaucoup de points communs avec la variante précédente, permet de faire subir au film fixé au substrat cible un certain nombre de traitements, par exemple des étapes technologiques de réalisation de composants électroniques dont des traitements thermiques à haute température. Ces traitements thermiques rendraient quasiment impossible le décollement d'un film sur un substrat obtenu par le procédé direct.

On a vu précédemment qu'il est possible d'obtenir un scellement de faible énergie du film sur le substrat cible, par exemple une énergie de 0,5 J/m². Le contrôle de la rugosité des surfaces avant mise en contact à des valeurs RMS supérieures à 0,6 nm permet d'obtenir de telles énergies de scellement malgré des traitements thermiques à une température supérieure à 900°C. Ces énergies sont alors compatibles pour pouvoir libérer le film dit processé, par décollement du substrat cible après la mise en oeuvre des étapes technologiques de réalisation de composants. Il est alors possible de récupérer le substrat cible, ce qui peut être avantageux en fonction de son coût.

A titre d'exemple de substrat cible de fort coût, on peut par exemple citer un substrat de silicium de 300 mm de diamètre. Seule la partie film du substrat est à utiliser pour les composants et il peut être important de récupérer le substrat initial et/ou le support intermédiaire et/ou le substrat cible.

Une cinquième variante de mise en oeuvre s'applique au cas où la surface libre du film 6 délimité dans le substrat initial est telle que l'adhésion directe sur un substrat cible est très faible, par exemple à cause des rugosités sur au moins une des deux surfaces à mettre en contact. L'énergie de scellement sur le substrat cible est alors insuffisante pour permettre la séparation du film par le procédé direct.

Pour résoudre ce problème, après l'étape d'implantation ionique, la première face de contact 8 est préparée pour la rendre apte à un scellement, par exemple par le dépôt d'un film sacrificiel et par une étape supplémentaire de lissage dite de planarisation. Selon l'invention, on utilise un support intermédiaire, par exemple un substrat de silicium éventuellement recouvert d'une couche d'oxyde (par exemple de 100 nm d'épaisseur) et présentant une face de contact peu rugueuse, par exemple avec une valeur moyenne RMS de 0,2 nm. Le fait de coller sur une surface faiblement rugueuse assure une énergie de scellement de valeur suffisante pour permettre par la suite l'étape de séparation du film 6 du reste du substrat initial.

Une fois la séparation réalisée, un traitement thermique à haute température peut être mis en oeuvre, par exemple pour renforcer le scellement ou en fonction des opérations nécessaires pour les applications visées (diffusion d'un élément implanté, film d'oxyde déposé par la suite, etc.). Un traitement de surface, par exemple un polissage mécano-chimique, permet de lisser tout ou partie de la surface révélée du film séparé de son substrat initial.

Après nettoyage, la surface libre du film 6 ou du film additionnel 13, dite deuxième face de contact 14, est scellée sur le substrat cible en silicium qui est par exemple recouvert d'une couche d'oxyde d'environ 1000 nm d'épaisseur dont la surface est rendue rugueuse par traitement chimique. Le scellement est éventuellement adapté par un traitement thermique mais conserve une faible valeur. A ce stade, l'énergie de scellement entre le film 6 ou le film 13 et le substrat cible 15 (ou éventuellement sa couche superficielle) est plus faible que celle nécessaire au bon déroulement de l'étape de séparation film-reste du substrat initial. Le support intermédiaire 10 est ensuite retiré par exemple par meulage et attaque chimique et la couche d'oxyde 3 est éliminée par attaque chimique. L'épaisseur finale du film 6 est adaptée par amincissement, par exemple par oxydation sacrificielle. Cette épaisseur peut être de 50 nm avec une très bonne homogénéité.

Avantageusement, cette cinquième variante sera utilisée lorsque la rugosité de surface initiale des faces 2 ou 8 correspond à une topologie gravée sur le substrat initial ou sur la couche mince initiale ou sur le substrat cible. Un film d'oxyde 13 (voir la figure 5) de 1000 nm d'épaisseur peut être réalisé, par exemple thermiquement, à la surface du film 6. La topologie de la surface, ne permettant pas initialement le procédé direct, peut être reproduite à cette étape, par exemple par un traitement de gravure chimique. On peut citer comme exemple d'application le cas de canaux placés au niveau de l'interface de scellement avec le substrat cible et aptes à induire un refroidissement de la structure par circulation d'un fluide. Dans un autre domaine, on peut citer la réalisation d'une texture à l'interface de scellement du substrat cible pour des applications photovoltaïques. De plus, cette topologie peut être exclusivement ou partiellement réalisée dans le substrat cible, couvert ou non de couches additionnelles.

Une sixième variante de mise en oeuvre se distingue de la variante précédente en ce que le support intermédiaire peut être récupéré. Cette solution s'avère intéressante car le support intermédiaire est un élément devant présenter une certaine qualité pour permettre la séparation des films et son coût peut alors être important. Le procédé selon l'invention permet par exemple et avantageusement de conserver l'énergie de scellement du substrat initial sur le support intermédiaire à une valeur juste supérieure à l'énergie seuil nécessaire pour permettre la séparation entre le film et le substrat initial. L'énergie de scellement du substrat initial et du support intermédiaire peut être contrôlée par le biais des rugosités des surfaces et de traitements thermiques utilisés éventuellement en complément du traitement de séparation. Etant donné que l'on peut recycler le support intermédiaire, on peut utiliser comme support des substrats chers (compatibles avec l'application) ou même préparés spécialement pour faciliter le décollement à l'interface de premier scellement. La récupération du support intermédiaire après son scellement au substrat cible peut être réalisée par exemple par une technique de "lift-off" ou de descellement mécanique et/ou pneumatique, ou encore suivant un procédé en combinaison avec une implantation gazeuse, ces techniques pouvant être combinées entre elles.

Une septième variante de mise en oeuvre s'applique notamment au cas où la surface libre du film séparé du substrat initial est difficile à polir ou présente une qualité de lissage insuffisante après un procédé direct.

Les films obtenus par le procédé direct présentent souvent après l'étape de séparation une rugosité de surface à diminuer pour l'application prévue. Classiquement, un polissage mécano-chimique peut être effectué. Pour beaucoup de matériaux, par exemple les matériaux "durs" (saphir, SiC, diamant, etc.), ce polissage est soit mal adapté (pas efficace pour polir un film du matériau dur alors qu'il a été mis au point pour le même matériau sous forme massive, qualité insuffisante, défaut d'homogénéité d'épaisseur), soit trop long (ce qui augmente le coût de fabrication). L'invention permet de résoudre ce problème.

Prenons l'exemple d'un substrat initial 1 constitué par une plaquette de saphir monocristalline d'orientation [1-102] et polie en surface avec une qualité épitaxiale. La plaquette peut éventuellement être recouverte d'une couche d'oxyde de silicium. Le substrat initial 1 est implanté par des espèces gazeuses, par exemple par de l'hydrogène. En l'absence de couche d'oxyde, l'énergie d'implantation peut être de 60 keV pour une dose de 2.10¹⁷ atomes/cm². En cas de présence de la couche d'oxyde, l'énergie d'implantation est alors augmentée pour tenir compte de l'épaisseur de cette couche d'oxyde. Après préparation de la face implantée (première face de contact), le substrat initial est mis en contact par adhésion moléculaire avec le support intermédiaire. La séparation du film de saphir est provoquée dans ou au voisinage de la couche fragilisée.

Après cette séparation, on désire obtenir un film de saphir de faible micro-rugosité. Pour ce type de matériau, un polissage mécano-chimique est très long à mettre en oeuvre et la qualité et l'homogénéité de polissage d'un film mince est difficile à maîtriser. La qualité de la surface n'étant pas de type épitaxial ou le surcoût impliqué étant important, le procédé direct ne peut être appliqué. Le substrat initial en saphir étant vendu par le fournisseur de plaques avec une face qui est déjà de qualité épitaxiale, l'invention permet l'obtention d'une structure empilée comprenant un film dont la face libre (ou face avant) est cette face initiale de qualité épitaxiale.

L'étape de séparation du film d'avec le reste du substrat initial est donc réalisée après mise en contact adhérent du substrat initial sur le support intermédiaire via un éventuel film initial additionnel. Après la séparation, la face libre du film de saphir présente une certaine rugosité. On y dépose une couche d'un matériau, par exemple une couche de SiO₂, et un polissage mécano-chimique permet une planarisation de sa surface. Après préparation de cette surface et de la surface correspondante du substrat cible (par exemple en silicium), la deuxième étape de mise en contact adhérent est réalisée. Le retrait du support intermédiaire révèle la face avant initiale du film de saphir ou du film initial additionnel. Ce film initial additionnel peut être avantageusement un film d'oxyde de silicium. Dans ce cas, il peut être retiré par attaque chimique pour libérer la face avant initiale du film de saphir. Si cette face avant est recouverte d'une couche d'oxyde, cette couche peut être retirée par une attaque chimique.

Une huitième variante de mise en oeuvre s'applique au cas où le film possède des faces présentant des caractéristiques différentes. C'est le cas mentionné dans l'état de la technique antérieure de la reprise de croissance par épitaxie sur le film 6, par exemple en SiC (matériau possédant une face de type Si et une face de type C) ou en GaN.

A titre d'exemple, un substrat initial de SiC est recouvert d'une couche d'oxyde d'environ 400 nm d'épaisseur. Le substrat initial est implanté, au travers de la couche d'oxyde, par des atomes d'hydrogène d'énergie 120 keV et selon une dose de 8.10¹⁶ atomes/cm². La surface implantée est ensuite rendue hydrophile et est mise en contact pour une liaison par adhésion moléculaire avec une face d'un support intermédiaire recouvert d'une couche d'oxyde de 1 *µ*m d'épaisseur par exemple. Un traitement de séparation permet de séparer le film du reste du substrat initial. Le film de SiC adhère alors au support intermédiaire via la couche d'oxyde. Un traitement de surface (par exemple un polissage mécano-chimique ou le dépôt d'un film permettant une planarisation) permet de rendre la nouvelle surface libre du film de SiC apte à une adhésion ultérieure. Cette surface libre est rendue hydrophile et est mise en contact pour une liaison par adhésion moléculaire avec une face correspondante du substrat cible. Après un traitement thermique à haute température destiné à renforcer le scellement, l'énergie d'adhésion moléculaire peut atteindre des valeurs supérieures ou égales à 1 J/m².

Le support intermédiaire 10 est ensuite retiré, par exemple par un meulage complété par une attaque chimique, la couche d'oxyde 3 servant de couche d'arrêt à la gravure. La couche d'oxyde 3 est enfin retirée par attaque au moyen d'une solution à base d'acide fluorhydrique. L'épaisseur finale du film est adaptée, par exemple grâce à un traitement thermique amincissant.

Dans cette variante de mise en oeuvre, une épaisseur finale du film 6 de 100 nm est obtenue avec une très bonne homogénéité sur une majeure partie de la structure. La surface libérée du film correspond à la surface apte à une reprise par croissance en épitaxie.

Une neuvième variante de mise en oeuvre s'applique au cas où l'on désire récupérer le support intermédiaire et où le film (ou l'un des films) possède des faces présentant des caractéristiques différentes. Cette variante est un cas particulier de la variante précédente.

Après l'étape consistant à séparer le film 6 du reste 9 du substrat initial (voir la figure 4), une étape d'implantation ionique est effectuée au travers de la surface 12 pour induire une zone fragilisée dans le substrat intermédiaire ou dans une des couches additionnelles déposées sur le substrat intermédiaire ou la couche mince 7 suivant leur nature. Il peut s'agir d'une implantation d'hydrogène dans le substrat intermédiaire à une énergie de 140 keV et selon une dose de 8.10¹⁶ atomes/cm² pour l'exemple des matériaux cités à la huitième variante et dans laquelle le substrat intermédiaire est en SiC.

Le substrat cible est mis en contact adhérent avec la deuxième face de contact. Le support intermédiaire est alors séparé de la structure empilée et peut être recyclé. Dans le cas d'un procédé de réalisation d'un film de SiC sur un substrat cible de silicium, la récupération du support intermédiaire en SiC est d'un intérêt économique certain. La couche d'oxyde 3 est retirée par attaque au moyen d'une solution d'acide fluorhydrique. L'épaisseur finale du film 6 est adaptée par amincissement, par exemple par oxydation sacrificielle.

Une dixième variante de mise en oeuvre se rapporte au cas où le film et le substrat cible ont au moins une caractéristique rendant incompatible le procédé direct. Il peut s'agir du cas où les matériaux constituant le film et le substrat cible ont des coefficients de dilatation thermique trop différents. A titre d'exemple on peut citer : le silicium et le quartz, le silicium et le saphir, le silicium et l'arséniure de gallium, Si et InP, Si et LiNbO₃. Un traitement thermique utilisé avant ou pendant l'étape de séparation, par le procédé direct, provoque soit un descellement à l'interface de mise en contact, soit une rupture de l'un des deux éléments mis en contact adhérent.

A titre d'exemple, on part d'un substrat initial 1 constitué d'une plaque de silicium recouverte d'une couche d'oxyde 3 de 400 nm d'épaisseur. Une couche fragilisée 5 est créée par implantation d'hydrogène à une énergie de 75 keV et avec une dose de 6.10¹⁶ atomes/cm². La face de contact 8 est scellée à un support intermédiaire 10 présentant un coefficient de dilatation thermique compatible. Ce support intermédiaire peut être une autre plaque de silicium recouverte d'une couche d'oxyde de 200 nm d'épaisseur. Des traitements thermiques peuvent alors être réalisés. Ces traitements thermiques permettent d'augmenter l'énergie de scellement, ce qui conduira à une séparation de qualité entre le film et le reste du substrat initial. Une fois la séparation réalisée, on obtient l'empilement représenté à la figure 4. Un traitement de surface permet de minimiser la micro-rugosité de surface du film 6. Après une éventuelle préparation de surface, l'empilement est scellé sur un substrat cible dont le coefficient de dilatation peut être très différent de celui du substrat initial, par exemple une plaque de quartz ou de saphir et le support intermédiaire est retiré par exemple par meulage, par attaque chimique, par lift-off..

Un autre exemple de cette dixième variante consiste à provoquer une adhésion à l'étape b) dont l'énergie corresponde au moins à l'énergie seuil en dessous de laquelle l'étape c) ne peut avoir lieu. Avant l'étape d), une implantation ionique, par exemple d'hydrogène, est réalisée dans le substrat intermédiaire ou dans une des couches additionnelles de ce substrat intermédiaire à travers la face 12. Cette implantation y induit une couche fragilisée dans laquelle s'effectuera la séparation lors de l'étape e). Le substrat intermédiaire peut alors être récupéré et réutilisé.

Des exemples analogues peuvent être obtenus avec des substrats initiaux constitués eux-mêmes d'une structure empilée, par exemple une plaque de silicium recouverte d'une couche de nitrure alors que le substrat cible peut être une plaque de silicium recouverte d'une couche épaisse d'oxyde thermique. Le coefficient de dilatation du film de nitrure peut être supérieur à 4.10⁻⁶/K alors que celui du film d'oxyde est inférieur à 10⁻⁶/K. Un traitement thermique à haute température utilisé lors ou à la suite du procédé direct, par exemple pour amincir le film de silicium par oxydation sacrificielle, n'est pas compatible pour certaines conditions d'énergie d'adhésion entre les films de nitrure et de silice. Dans ce cas, l'usage du procédé selon l'invention permet de résoudre le problème. Après l'étape c), la couche mince est traitée à haute température pour l'amincir par oxydation sacrificielle du silicium. Avant l'étape d), une couche additionnelle de nitrure (Si₃N₄) est réalisée sur la face libre de la couche mince et le substrat cible est recouvert d'un film d'oxyde (SiO₂). Les deux couches peuvent aussi être déposées sur la face libre de la couche mince ou sur le substrat cible. La structure empilée finale correspond à la couche amincie de silicium supportée par les deux films de coefficients de dilatation très différents.

Suivant une onzième variante, la caractéristique rendant incompatible le procédé direct peut être un changement de phase survenant dans un film. Par exemple, un film de palladium mis en contact avec un substrat de silicium permet une adhésion en formant un siliciure grâce à un traitement thermique à une température au-dessus de 200°C. Par contre, à 900°C, ce siliciure se dégrade, rendant par exemple ainsi impossible une étape d'oxydation sacrificielle à 900°C dans le procédé direct. L'invention permet de résoudre ce problème.

Après réalisation d'une couche mince 7 comportant un film de silicium 6 sur un support intermédiaire 10, le film de silicium est aminci à 900°C par oxydation sacrificielle, puis le film de palladium est déposé après l'étape de lissage de la face libre 12 et constitue tout ou partie du film référencé 13. Le traitement thermique de scellement avec le substrat cible étant réalisé à une température inférieure à 870°C, le scellement sera de bonne qualité et le film de silicium sera à la bonne épaisseur.

## Revendications

1. Procédé de fabrication d'une structure empilée comprenant au moins une couche mince adhérant à un substrat cible (15), comportant les étapes suivantes :
a) formation d'une couche mince (7) à partir d'un substrat initial (1), la couche mince (7) présentant une face libre appelée première face de contact (8), la formation de la couche mince comprenant l'introduction d'espèces gazeuses dans le substrat initial (1), au travers de l'une (2) de ses faces correspondant à ladite première face de contact (8), pour former une couche fragilisée (5) séparant un film (6) du reste (9) du substrat initial (1) et devant conduire à une fracture du substrat initial lors de l'étape c),
b) mise en contact adhérent de la première face de contact (8) avec une face (11) d'un support (10), la structure obtenue étant compatible avec un amincissement ultérieur du substrat initial,
c) amincissement dudit substrat initial (1) pour exposer une face libre de la couche mince appelée deuxième face de contact (14) et opposée à la première face de contact (8), l'amincissement résultant d'un traitement thermique permettant l'obtention de la fracture du substrat initial (1) au niveau de la couche fragilisée (5),
**caractérisé en ce que**
le support (10) mis en contact adhérent avec la couche mince n'étant pas le substrat cible mais étant un substrat intermédiaire, le procédé comprend en outre les étapes de :
d) mise en contact adhérent d'une face du substrat cible (15) avec au moins une partie de la deuxième face de contact (14), la structure obtenue étant compatible avec un retrait ultérieur de tout ou partie du support intermédiaire,
e) retrait d'au moins une partie du support intermédiaire (10) permettant l'obtention de ladite structure empilée.

2. Procédé selon la revendication 1, **caractérisé en ce que** le substrat cible n'est qu'un support provisoire pour la couche mince, lesdites étapes du procédé étant en totalité ou en partie répétées, le substrat cible étant assimilé au substrat initial ou au support intermédiaire.

3. Procédé selon la revendication 1, **caractérisé en ce que** le contact adhérent de la première face de contact et/ou de la deuxième face de contact de la couche mince permettant ladite compatibilité à l'étape b) et/ou à l'étape d) résulte de l'utilisation d'un traitement permettant le contact adhérent, ledit traitement étant choisi, seul ou en combinaison, parmi les traitements suivants : polissage mécano-chimique et/ou ionique, interposition d'une couche intermédiaire entre une face de contact correspondante de la couche mince et le support intermédiaire ou le substrat cible, traitement thermique et traitement chimique.

4. Procédé selon la revendication 1, **caractérisé en ce que** la mise en contact adhérent de l'étape b) et/ou de l'étape d) est réalisée par adhésion moléculaire.

5. Procédé selon la revendication 1, **caractérisé en ce que** la première face de contact de la couche mince présente une polarité en surface (polarité liée à la nature des atomes de cette surface) différente de celle de sa deuxième face de contact, la compatibilité de structure de l'étape d) étant obtenue grâce à la mise en contact adhérent de la deuxième face de contact de la couche mince et du substrat cible, et grâce au retrait du support intermédiaire de la première face de contact de la couche mince qui devient ainsi une face libre.

6. Procédé selon la revendication 1, **caractérisé en ce que** la compatibilité de structure réalisée à l'étape d) est obtenue grâce à la mise en contact adhérent de la deuxième face de contact de la couche mince avec le substrat cible avec une énergie de liaison apte à un éventuel retrait du substrat cible après l'étape e).

7. Procédé selon la revendication 1, **caractérisé en ce que**, entre l'étape c) et l'étape d), il est prévu une étape intermédiaire consistant à réaliser des cavités ou tout ou partie de composants dans la deuxième face de contact de la couche mince et/ou dans le substrat cible, la structure obtenue après l'étape d) étant compatible avec la présence des cavités ou du tout ou partie de composants.

8. Procédé selon la revendication 1, **caractérisé en ce que**, avant l'étape d), il est prévu une étape intermédiaire consistant en une opération de détourage permettant d'isoler au moins une zone de la deuxième face de contact, l'étape d) mettant en contact adhérent au moins une de ces zones avec le substrat cible.

9. Procédé selon la revendication 1, **caractérisé en ce que** l'étape a) est réalisée à partir d'un substrat (1) recouvert d'au moins une couche (3).

10. Procédé selon la revendication 9, **caractérisé en ce que**, après l'étape e), le procédé comporte une étape consistant à éliminer la couche (3) recouvrant le substrat (1) de l'étape a).

11. Procédé selon l'une des revendications 9 ou 10, **caractérisé en ce que** le substrat initial (1) étant en silicium, la couche (3) qui le recouvre est en oxyde de silicium.

12. Procédé selon la revendication 1, **caractérisé en ce que** le retrait d'au moins une partie du support intermédiaire est effectué par une introduction d'espèces gazeuses effectuée soit au travers de la couche mince après mise en contact, soit au travers de la face de contact du support intermédiaire avant ou après sa mise en contact adhérent avec la première face de contact de la couche mince, cette introduction d'espèces gazeuses formant une couche fragilisée permettant le retrait par fracture d'une partie du support intermédiaire.

13. Procédé selon la revendication 1, **caractérisé en ce que** la structure empilée obtenue à l'issue de l'étape e) est amincie du côté de la première face de contact.

14. Procédé selon la revendication 1, **caractérisé en ce qu'**il met en oeuvre un substrat initial en silicium monocristallin, un support intermédiaire en silicium monocristallin, un substrat cible en silicium polycristallin ou monocristallin de moindre qualité que le silicium du substrat initial.

15. Procédé selon la revendication 1, **caractérisé en ce qu'**il met en oeuvre un substrat initial en SiC ou en GaAs, un support intermédiaire en SiC ou en GaAs, un substrat cible en SiC ou en GaAs de moindre qualité que le matériau du substrat initial, la couche mince comportant du SiC ou du GaAs provenant du substrat initial.

16. Procédé selon la revendication 1, **caractérisé en ce que** la couche mince est une couche de matériau choisi parmi Si, GaN, SiC, LiNbO₃, Ge, GaAs, InP, le saphir et les semi-conducteurs.

## Patentansprüche

1. Verfahren zum Herstellen einer Stapelstruktur mit zumindest einer an einem Zielsubstrat (15) anhaftenden dünnen Schicht, umfassend die nachfolgenden Schritte:
a) Bilden einer dünnen Schicht (7) aus einem ursprünglichen Substrat (1), wobei die dünne Schicht (7) eine freie Fläche, erste Kontaktfläche (8) genannt, aufweist, wobei das Bilden der dünnen Schicht das Einführen von gasförmigen Spezien in das ursprüngliche Substrat (1) durch eine (2) seiner Flächen umfasst, die der ersten Kontaktfläche (8) entspricht, um eine versprödete Schicht (5) zu bilden, die einen Film (6) vom Rest (9) des ursprünglichen Substrats (1) trennt und zu einem Bruch des ursprünglichen Substrats bei Schritt c) führen muss,
b) Inhaftkontaktbringen der ersten Kontaktfläche (8) mit einer Fläche (11) eines Trägers (10), wobei die erhaltene Struktur mit einer nachträglichen Verjüngung des ursprünglichen Substrat kompatibel ist,
c) Verjüngen des ursprünglichen Substrats (1), um eine freie Fläche der dünnen Schicht, zweite Kontaktfläche (14) genannt, die der ersten Kontaktfläche (8) entgegengesetzt ist, freizulegen, wobei die Verjüngung sich aus einer Wärmebehandlung ergibt, wodurch der Bruch des ursprünglichen Substrats (1) im Bereich der versprödeten Schicht (5) erhalten werden kann, **dadurch gekennzeichnet, dass**
der Träger (10), der mit der dünnen Schicht in Haftkontakt gebracht ist, nicht das Zielsubstrat ist, sondern ein Zwischensubstrat ist, wobei das Verfahren ferner die nachfolgenden Schritte umfasst:
d) Inhaftkontaktbringen einer Fläche des Zielsubstrats (15) mit zumindest einem Teil der zweiten Kontaktfläche (14), wobei die erhaltene Struktur mit einem nachträglichen Entfernen des gesamten Zwischenträgers oder eines Teils davon kompatibel ist,
e) Entfernen zumindest eines Teils des Zwischenträgers (10), wodurch die Stapelstruktur erhalten werden kann.

2. Verfahren nach Anspruch 1, **dadurch gekennzeichnet, dass** das Zielsubstrat nur ein vorübergehender Träger für die dünne Schicht ist, wobei die Verfahrensschritte insgesamt oder teilweise wiederholt werden, wobei das Zielsubstrat mit dem ursprünglichen Substrat bzw. mit dem Zwischenträger gleichgesetzt ist.

3. Verfahren nach Anspruch 1, **dadurch gekennzeichnet dass** der Haftkontakt der ersten Kontaktfläche und/oder der zweiten Kontaktfläche der dünnen Schicht, welcher die Kompatibilität in Schritt b) und/oder in Schritt d) gestattet, sich aus der Durchführung einer Behandlung ergibt, welche den Haftkontakt gestattet, wobei die Behandlung aus den nachfolgenden Behandlungen allein oder in Kombination ausgewählt ist: chemisch-mechanisches und/oder ionisches Polieren, Einfügen einer Zwischenschicht zwischen einer der dünnen Schicht entsprechenden Kontaktfläche und dem Zwischenträger bzw. dem Zielsubstrat, Wärmebehandlung und chemische Behandlung.

4. Verfahren nach Anspruch 1, **dadurch gekennzeichnet, dass** das Inhaftkontaktbringen von Schritt b) und/oder Schritt d) durch molekulare Haftung erfolgt.

5. Verfahren nach Anspruch 1, **dadurch gekennzeichnet, dass** die erste Kontaktfläche der dünnen Schicht eine Oberflächenpolarität (mit der Beschaffenheit der Atome dieser Fläche zusammenhängende Polarität) aufweist, die sich von der ihrer zweiten Kontaktfläche unterscheidet, wobei die Strukturkompatibilität von Schritt d) aufgrund des Inhaftkontaktbringens der zweiten Kontaktfläche der dünnen Schicht und des Zielsubstrats und aufgrund des Entfernens des Zwischenträgers von der ersten Kontaktfläche der dünnen Schicht erhalten wird, die somit eine freigelegte Fläche wird.

6. Verfahren nach Anspruch 1, **dadurch gekennzeichnet, dass** die in Schritt d) geschaffene Strukturkompatibilität aufgrund des Inhaftkontaktbringens der zweiten Kontaktfläche der dünnen Schicht mit dem Zielsubstrat mit einer Verbindungsenergie, die zu einem eventuellen Entfernen des Zielsubstrats nach Schritt e) geeignet ist, erhalten wird.

7. Verfahren nach Anspruch 1, **dadurch gekennzeichnet, dass** zwischen Schritt c) und Schritt d) ein Zwischenschritt vorgesehen ist, der darin besteht, Hohlräume oder sämtliche Komponenten oder Teile davon in der zweiten Kontaktfläche der dünnen Schicht und/oder in dem Zielsubstrat auszuführen, wobei die nach Schritt d) erhaltene Struktur mit den vorhandenen Hohlräumen oder sämtlichen Komponenten oder einem Teil davon kompatibel ist.

8. Verfahren nach Anspruch 1, **dadurch gekennzeichnet, dass** vor Schritt d) ein Zwischenschritt vorgesehen ist, der aus einem Zuschneiden besteht, wodurch zumindest ein Bereich der zweiten Kontaktfläche abgetrennt werden kann, wobei der Schritt d) zumindest einen dieser Bereiche mit dem Zielsubstrat in Haftkontakt bringt.

9. Verfahren nach Anspruch 1, **dadurch gekennzeichnet, dass** Schritt a) ausgehend von einem Substrat (1) durchgeführt wird, das mit zumindest einer Schicht (3) bedeckt ist.

10. Verfahren nach Anspruch 9, **dadurch gekennzeichnet, dass** nach Schritt e) das Verfahren einen Schritt umfasst, der darin besteht, die das Substrat (1) bedeckende Schicht (3) von Schritt a) zu beseitigen.

11. Verfahren nach einem der Ansprüche 9 oder 10, **dadurch gekennzeichnet, dass** das ursprüngliche Substrat (1) aus Silicium besteht, wobei die dieses bedeckende Schicht (3) aus Siliciumoxid besteht.

12. Verfahren nach Anspruch 1, **dadurch gekennzeichnet, dass** das Entfernen von zumindest einem Teil des Zwischensubstrats durch das Einführen von gasförmigen Spezien entweder durch die dünne Schicht nach dem Inkontaktbringen oder durch die Kontaktfläche des Zwischenträgers vor oder nach seinem Inhaftkontaktbringen mit der ersten Kontaktfläche der dünnen Schicht erfolgt, wobei dieses Einführen von gasförmigen Spezien eine versprödete Schicht bildet, die das Entfernen eines Teils des Zwischenträgers durch Bruch gestattet.

13. Verfahren nach Anspruch 1, **dadurch gekennzeichnet, dass** die nach Abschluss von Schritt e) erhaltene Stapelstruktur auf der Seite der ersten Kontaktfläche verjüngt wird.

14. Verfahren nach Anspruch 1, **dadurch gekennzeichnet, dass** ein ursprüngliches Substrat aus monokristallinem Silicium, ein Zwischenträger aus monokristallinem Silicium, ein Zielsubstrat aus polykristallinem oder monokristallinem Silicium, das geringwertiger als das Silicium des ursprünglichen Substrats ist, gebildet werden.

15. Verfahren nach Anspruch 1, **dadurch gekennzeichnet, dass** ein ursprüngliches Substrat aus SiC oder GaAs, ein Zwischenträger aus SiC oder GaAs, ein Zielsubstrat aus SiC oder GaAs, das geringwertiger als das Material des ursprünglichen Substrats ist, gebildet werden, wobei die dünne Schicht SiC oder GaAs enthält, das aus dem ursprünglichen Substrat stammt.

16. Verfahren nach Anspruch 1, **dadurch gekennzeichnet, dass** die dünne Schicht eine Schicht aus einem Material, ausgewählt aus Si, GaN, SiC, LiNbO₃, Ge, GaAs, InP, Saphir und Halbleitern, ist.

## Claims

1. Process for manufacturing a stacked structure comprising at least one thin layer bonded to a target substrate (15), comprising the following steps:
a) formation of a thin layer (7) starting from an initial substrate (1), the thin layer (7) having a free face called the first contact face (8), the formation of the thin layer comprising the introduction of gaseous compounds into the initial substrate (1), through one (2) of its faces corresponding to the said first contact face (8), to form a weakened layer (5) separating a film (6) from the rest (9) of the initial substrate and leading to a fracture of the initial substrate during step c),
b) putting the first contact face into bonding contact (8) with a face (11) of a support (10), the structure obtained being compatible with later thinning of the initial substrate,
c) thinning of the said initial substrate (1) to expose a free face of the thin layer called the second contact face (14) and opposite the first contact face (8), the thinning resulting from a thermal treatment that allows to obtain the fracture in the initial substrate (1) at the weakened layer (5),
**characterized in that** the support (10) put into bonding contact with the thin layer is not the target substrate but an intermediate substrate, the process further comprising the steps of:
d) putting a face of the target substrate (15) into bonding contact with at least part of the second contact face (14), the structure obtained being compatible with later removal of all or some of the intermediate support,
e) removal of at least part of the intermediate support (10) in order to obtain the said stacked structure.

2. Process according to claim 1, **characterized in that** the target substrate is only a temporary support for the thin layer, the said steps in the process being entirely or partly repeated, the target substrate being treated as the initial substrate or the intermediate support.

3. Process according to claim 3, **characterized in that** the bonding contact of the first contact face and/or the second contact face of the thin layer enabling the said compatibility in step b) and/or in step d) is a result of the use of a treatment enabling bonding contact, said treatment being chosen, alone or in combination, among the treatments including mechanical-chemical and/or ionic polishing, insertion of an intermediate layer between a corresponding contact face of the thin layer and the intermediate support or the target substrate, heat treatment and chemical treatment.

4. Process according to claim 1, **characterized in that** the bonding contact in step b) and/or in step d) is achieved by molecular bonding.

5. Process according to claim 1, **characterized in that** the surface polarity of the first contact face of the thin layer (polarity related to the nature of the atoms on this surface) is different from the polarity of its second contact face, the compatibility of the structure in step d) being obtained by putting the second contact face of the thin layer and the target substrate into bonding contact, and due to the removal of the intermediate support of the first contact face of the thin layer that thus becomes a free face.

6. Process according to claim 1, **characterized in that** the structure compatibility achieved in step d) is obtained by creating a bonding contact of the second contact face of the thin layer with the target substrate with a bonding energy that enables removal of the target substrate after step e).

7. Process according to claim 1, **characterized in that** an intermediate step is carried out between step c) and step d), consisting of making cavities or all or part of components in the second contact face of the thin layer and/or the target substrate, the structure obtained after step d) being compatible with the presence of said cavities or all or part of said components.

8. Process according to claim 1, **characterized in that** an intermediate step is performed before step d), consisting of a trimming operation in order to isolate at least one area of the second contact face, step d) putting at least one of these areas into bonding contact with the target substrate.

9. Process according to claim 1, **characterized in that** the step a) is done starting from a substrate (1) covered by at least one layer of material (3).

10. Process according to claim 9, **characterized in that** after step e), the process comprises a step consisting of eliminating the layer covering the substrate (1) in step a).

11. Process according to anyone of claims 19 or 20, **characterized in that** the initial substrate (1) is made of silicon, and the layer of material (3) that covers it is made of silicon oxide.

12. Process according to claim 1, **characterized in that** at least part of the intermediate support is removed by the introduction of gaseous compounds either through the thin layer after creating a contact, or through the contact face of the intermediate support before or after putting it into bonding contact with the first contact face of the thin layer, this introduction of gaseous compounds forming a weakened layer enabling the removal of all or part of the intermediate support.

13. Process according to claim 1, **characterized in that** the stacked structure obtained at the end of step e) is thinned on the side of the first contact face.

14. Process according to claim 1, **characterized in that** it uses an initial substrate made of monocrystalline silicon, an intermediate support made of monocrystalline silicon, a target substrate made of polycrystalline or monocrystalline silicon of lower quality than the silicon in the initial substrate.

15. Process according to claim 1, **characterized in that** it uses a SiC or GaAs initial substrate, a SiC or GaAs intermediate support, a SiC or GaAs target substrate with a lower quality than the initial substrate material, the thin layer containing SiC or GaAs originating from the initial substrate.

16. Process according to claim 1, **characterized in that** the thin layer is a layer of a material from Si, GaN, SiC, LiNb0₃, Ge, GaAS, InP, sapphire and semiconductors.
